# EUROPEAN PATENT APPLICATION

(11) **EP 4 461 846 A1**
(43) Date of publication of application: **13.11.2024**
(21) Application number: 22918760.4
(22) Date of filing: 07.12.2022
(51) Int. Cl.: C23C 16/448, C23C 16/40, H01L 21/365, H01L 21/368

(54) **FILM FORMING APPARATUS AND FILM FORMING METHOD**

(30) Priority: 05.01.2022 JP 2022000733
(71) Applicant: SHIN-ETSU CHEMICAL CO., LTD., Tokyo 1000005 (JP)
(72) Inventor: HASHIGAMI, Hiroshi, Annaka-shi, Gunma 379-0195 (JP)
(74) Representative: Mooser, Sebastian Thomas
(86) International application number: PCT/JP2022/045003
(87) International publication number: WO 2023/132174

(57) **Abstract**

The present invention is a film forming apparatus including an atomizing means for atomizing a raw material solution to form a raw material mist, a carrier gas supply means to transport the raw material mist, a mist supply means to supply a gas mixture, in which the raw material mist and the carrier gas are mixed, to a surface of a substrate, a stage on which the substrate is placed, a measurement means for directly or indirectly measuring a supply amount of the raw material mist to output a signal in accordance with a measured value obtained by the measurement, and a control means for receiving the signal to adjust the supply amount of the raw material mist based on the signal. This provides the film forming apparatus capable of excellent control of the raw material supply and stable production of high-quality film.

## Description

### TECHNICAL FIELD

The present invention relates to a film forming apparatus and a film forming method in which an atomized liquid raw material is supplied to a substrate to form a film.

### BACKGROUND ART

A Mist Chemical Vapor Deposition (Mist CVD, hereinafter also referred to as "Mist CVD Method") is known as a method capable of forming a variety of thin films on substrates under low temperatures and atmospheric pressure atmosphere. Raw material mist, which is a characteristic of the Mist CVD method, is generally used with the mist generated by ultrasonic atomization (also referred to as mist-generating). This is because the raw material mist obtained by ultrasonic atomization has fine droplets suitable for film forming and a relatively good particle size distribution, which is easy to obtain. Patent Document 1 discloses a method for generating a mist by an ultrasonic vibrator from a raw material solution, in which gallium acetylacetonate complex is dissolved in a mixed solution of hydrochloric acid and water, and supplying the mist on a sapphire substrate placed in a narrow space (fine channel) provided in a reactor, and then to form an α-Ga₂O₃ film on the substrate heated from 350°C to 500°C.

On the other hand, a problem in generating the mist by the ultrasonic atomization is that an atomizing amount is prone to fluctuate. This causes problems such as large discrepancies in film thicknesses from batch to batch or fluctuations in a film composition that prevent a desired film function from being obtained. The fluctuation of the atomizing amount is due in part to a change in a temperature of the raw material solution by ultrasonic vibration and thereby fluctuates atomizing efficiency accordingly. For this reason, an apparatus configuration that holds the temperature of the raw material solution directly or indirectly has been adopted. For example, Patent Document 2 discloses an atomizing apparatus to perform temperature control by circulating an ultrasonic transmitting solution that transmits ultrasonic waves to a raw material solution and a Mist CVD apparatus provided with the atomizing apparatus.

### CITATION LIST

### PATENT LITERATURE

Patent Document 1: JP 2013-028480 A
Patent Document 2: JP 2016-190174 A

### SUMMARY OF INVENTION

### TECHNICAL PROBLEM

However, a temperature adjustment of an ultrasonic transmitting solution is unable to perform a temperature adjustment of raw material solutions immediately, resulting in insufficient control of a supply amount of a mist after all. Moreover, even in regard to another cause of atomizing amount fluctuation, i.e., atomizing amount decrease due to degradation or failure of mist generators such as ultrasonic vibrators, has not been observed in any examples in which film forming apparatuses are capable of maintaining a necessary supply of raw material mist, so far.

The present invention has been made in view of the above-described problem. An object of the present invention is to provide a film forming apparatus having excellent controllability of a raw material supply and capable of stable producing a film having uniform quality. Moreover, an object is to provide a film forming method capable of stably producing the film having uniform quality.

### SOLUTION TO PROBLEM

To achieve the object, the present invention provides a film forming apparatus comprising:
an atomizing means for atomizing a raw material solution to form a raw material mist;
a carrier gas supply means to transport the raw material mist;
a mist supply means to supply a gas mixture, in which the raw material mist and the carrier gas are mixed, to a surface of a substrate;
a stage on which the substrate is placed;
a measurement means for directly or indirectly measuring a supply amount of the raw material mist to output a signal in accordance with a measured value obtained by the measurement; and
a control means for receiving the signal to adjust the supply amount of the raw material mist based on the signal.

According to such the film forming apparatus, the supply amount of the raw material mist can always be maintained at a constant level, thereby making the film forming apparatus capable of stably producing the film having uniform quality.

In this case, it is preferred that the control means controls the atomizing means to adjust the supply amount of the raw material mist.

According to such a film forming apparatus, controlling the supply amount of the raw material mist can be precisely performed, thereby making stabilization of a raw material supply much easier and making the film forming apparatus capable of producing a more uniform film.

In this case, it is preferred that the control means controls the carrier gas supply means to adjust the supply amount of the raw material mist.

According to such a film forming apparatus, the control of the supply amount of the raw material solution mist can be more precisely performed, thereby making stabilization of the raw material supply much easier and making the film forming apparatus capable of producing the more uniform film.

Moreover, the present invention provides a forming method in which a raw material mist generated by atomizing a raw material solution is supplied on a surface of a substrate to form a film on the substrate, the method comprising the steps of:
placing the substrate on a stage;
atomizing the raw material solution to generate the raw material mist;
mixing the raw material mist and a carrier gas to form a gas mixture; and
supplying the gas mixture to the substrate to form a film on the substrate, wherein
in supplying the gas mixture to the substrate to form a film on the substrate, a supply amount of the raw material mist is measured directly or indirectly, a deviation of a measured value obtained by the measurement and the supply amount of raw material from a reference value is calculated, and one or both of an atomizing amount of the raw material solution and a supply amount of the carrier gas are adjusted so as to eliminate the deviation.

According to such a film forming method, the supply amount of the raw material mist can always be maintained at a constant level, thereby stably producing a film having uniform quality.

In this case, it is preferred that an object for the measurement is any raw material mist, a precipitate from the raw material mist, a by-product derived from the raw material mist, or a mixture thereof.

According to such a film forming method, the supply amount of the raw material mist can be determined quickly; therefore, controlling the supply amount of the raw material mist becomes easier, and thus the more uniform film can be produced.

### ADVANTAGEOUS EFFECTS OF INVENTION

As described above, according to the present invention, the film forming apparatus that can always stably produce the film having uniform quality can be obtained. Moreover, according to the present invention, the film having uniform quality can be stably produced. Furthermore, a number of failures can be reduced (yield is improved), resulting in a highly productive film forming apparatus and film forming method.

### BRIEF DESCRIPTION OF DRAWINGS

FIG. 1 is a view illustrating one form of a film forming apparatus according to the present invention.
FIG. 2 is a view illustrating one form of an atomizing means in a film-forming apparatus according to the present invention.

### DESCRIPTION OF EMBODIMENTS

As described above, developments of a film forming apparatus and a film forming method having excellent controllability of a raw material supply and being capable of stably producing a film having uniform quality have been desired.

To solve the above problem, the present inventor has earnestly studied and found out that measurement and control of the supply amount of a raw material mist enable stable production of the film having uniform quality. This finding has led to the completion of the present invention.

That is, the present invention is a film forming apparatus comprising:
an atomizing means for atomizing a raw material solution to form a raw material mist;
a carrier gas supply means to transport the raw material mist;
a mist supply means to supply a gas mixture, in which the raw material mist and the carrier gas are mixed, to a surface of a substrate;
a stage on which the substrate is placed;
a measurement means for directly or indirectly measuring a supply amount of the raw material mist to output a signal in accordance with a measured value obtained by the measurement; and
a control means for receiving the signal to adjust the supply amount of the raw material mist based on the signal.

In addition, the present invention is a film forming method in which a raw material mist generated by atomizing a raw material solution is supplied on a surface of a substrate to form a film on the substrate, the method comprising the steps of:
placing the substrate on a stage;
atomizing the raw material solution to generate the raw material mist;
mixing the raw material mist and a carrier gas to form a gas mixture and
supplying the gas mixture to the substrate to form a film on the substrate, wherein
in supplying the gas mixture to the substrate to form a film on the substrate, a supply amount of the raw material mist is measured directly or indirectly, a deviation of a measured value obtained by the measurement and the supply amount of raw material from a reference value is calculated, and one or both of an atomizing amount of the raw material solution and a supply amount of the carrier gas are adjusted so as to eliminate the deviation.

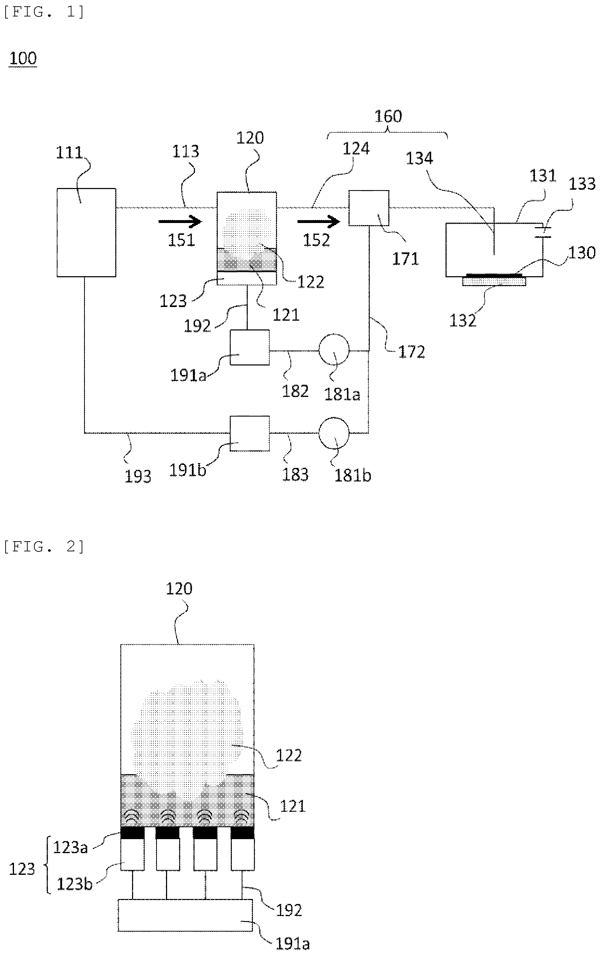

Hereinafter, the present invention will be described in detail with reference to FIG. 1 and FIG. 2. However, the present invention is not limited thereto.

### [Film Forming Apparatus]

An inventive film forming apparatus includes an atomizing means, a carrier gas supply means, a mist supply means, a stage on which the substrate is placed, a measurement means for directly or indirectly measuring a supply amount of the raw material mist to output a signal in accordance with a measured value obtained by the measurement, and a control means for receiving the signal to adjust the supply amount of the raw material mist based on the signal. Hereinafter, a detail of the apparatus is described.

FIG. 1 is a view describing one form of a configuration of the film forming apparatus suitably used for the present invention. A film forming apparatus 100 suitably used for the present invention includes an atomizing means 123 in contact with a raw-material container 120 that generates a raw material mist 122 by atomizing a raw material solution 121, and a film forming chamber 131 supplying the raw material mist 122 to a substrate 130 to form a film on the substrate 130.

The film forming apparatus 100 further includes a carrier gas supply means 111; and then the carrier gas supply means 111, the raw-material container 120, and the film forming chamber 131 are connected by a pipe 113 and a pipe 124. A carrier gas 151 and the raw material mist 122 are mixed in the raw-material container 120 to form a gas mixture 152, which is supplied to the film forming chamber 131 by a mist supply means 160. In addition, the pipe 124 is provided with a measurement means 171 to measure a passage amount of the raw material mist 122 in the gas mixture 152; and the measurement means 171, a calculating means 181a, 181b, a control means 191a and 191b for controlling a supply amount of mist, the atomizing means 123 and the carrier gas supply means 111 are connected by wirings 172, 182, 183, 192, and 193.

### (Raw Material Solution)

The raw material solution 121 is not particularly limited as long as the solution can be formed to the mist; in addition to an organic compound, metals dissolved or dispersed in solvents being water or organic solvents in a form of a complex or a salt can be used.

In this case, acids such as hydrochloric acid, hydrobromic acid, and hydroiodic acid, and alkalis such as ammonia may be added to the solvent to adjust pH of the solvent for use.

### (Atomizing Means)

The atomizing means 123 of the raw material solution 121 is not particularly limited as long as atomizing or forming droplets of the raw material solution 121 is possible, and any known means may be used; however, an atomizing means using ultrasonic is preferable in the present invention. The mists or droplets obtained by using the ultrasonic waves are preferable because of having an initial velocity of zero and floating in an air; thus, for example, it is the mist that can be transported as a gas floating in the air, not sprayed like a spray, resulting in very suitable for causing no damage due to collision energy. The droplet size is not particularly limited and may be the droplet having about a few mm, preferably 50 um or less, more preferably 0.1 to 10 µm.

In the case of an ultrasonic atomization, as shown in FIG. 2, the atomizing means 123 can be configured with a plurality of ultrasonic vibrators 123a and a plurality of drive circuits 123b that drive each ultrasonic vibrator 123a, for example. Note that the number of pairs of the ultrasonic vibrator 123a and the drive circuit 123b is not limited to a form in FIG. 2 but may be 3 pairs or less or 5 pairs or more.

A frequency of the ultrasonic waves oscillating from the ultrasonic vibrator 123a is not limited as long as the mist having a desired particle diameter and particle size distribution is generated; for example, 1.0 MHz to 4.0 MHz may be used. In addition, when the atomizing means is provided with a plurality of the ultrasonic vibrators 123a, an oscillation frequency of each of ultrasonic vibrators 123a may be, for example, different or the same within a range of the above frequency, depending on the purpose.

In this way, the raw material solution 121 is atomized into micron-sized droplets (the raw material mist) suitable for forming the film.

### (Raw Material Container)

A raw material container 120 may be provided with a plurality of containers depending on the materials to be formed, etc. Also, in this case, gas mixtures 152 supplied from a plurality of the raw-material containers 120 to the film forming chamber 131 may be supplied independently to the film forming chamber 131 or mixed in a pipe 124 or in a container for mixing (not shown) which is provided separately. In this case, it is preferred that a control means 191a, described later, is installed on each of the raw-material containers.

The raw-material container 120 may further include a temperature control means (not shown) to control the temperature of the raw material solution 121 directly or indirectly. The temperature of the raw material solution 121 is not particularly limited as long as the temperature at which atomization is possible but may be preferably 10°C to 90°C, more preferably 20°C to 50°C. In this way, the temperature drop on a film forming surface of the substrate 130 is mitigated, enabling better film forming. When the temperature is 90°C or less, vaporization of the raw material mist 122 is effectively suppressed, and thus, a yield in the film forming can be maintained stably, and failures on the film surface can be reduced more stably.

The raw material container 120 may further include a means, not shown, to supplement the raw material solution 121. In this case, the means to supplement the raw material solution 121 may further include a sensor to detect weight or liquid level of the raw material solution 121 directly or indirectly. In this case, known measurement methods can be widely applied to the sensor; and a liquid level sensor, a load cell, or a pressure sensor installed to contact with the raw material solution 121 at the bottom of the raw material container 120 can be suitably used. In addition, these sensors can be measurement means described later in detail. In this case, an amount of the raw material solution supplied to the film forming chamber 131 can be calculated as a time derivative of a measured value owing to the above sensors, etc.

### (Carrier Gas Supply Means)

The carrier gas supply means 111 supplies the carrier gas 151. The type of carrier gas 151 is not particularly limited; in addition to inert gases such as nitrogen or argon, air, oxygen, ozone, or reducing gases such as hydrogen or forming gas, a mixture of a plurality of these gases can be used. Moreover, the carrier gas supply means 111 may be an air compressor, various gas cylinders, or a nitrogen gas separator. Furthermore, the carrier gas supply means 111 may include a known liquid flow regulator to adjust a supply flow rate of the carrier gas, such as a flow meter or a mass flow controller. The supply flow rate of the carrier gas may be determined appropriately according to a substrate size or the size of the film forming chamber and can be, for example, about 0.01 to 100 L/min.

### (Measurement Means)

The measurement means 171 is installed to the pipe 124 to continuously measure the supply amount of the raw material mist contained in a gas mixture 152. The measurement of the supply amount of raw material mist supply can be performed by a light scattering method, a condensation nuclei counting method, an aerosol electrometer method, a piezobalance method, in addition, a method to weigh the mist collected by a mist trap, a filter, etc. or a precipitate obtained by evaporating the liquid component of the mist, or any other known measurement methods can be applied. The mist thereof flowing in pipe 124 may be measured, or a form may be applicable in which a branch pipe is installed to the pipe 124 for sampling a small amount of mist to measure for calculating. When a plurality of pipes 124 is installed, the measurement means 171 is preferably installed to all of these pipes.

Note that a measuring object of the measurement means 171 is not limited to the mist flowing in the pipe 124 but can also be the mist or by-product such as powder or mixtures thereof in the raw material mist 122, the film forming chamber 131, or those discharged from an exhaust pipe 133; moreover, as another form, the liquid volume of raw material solution 121 can be used as the measuring object, but in the present invention, mist and by-products are preferred over raw material solution because they can be measured more accurately in many cases. When a liquid measure of the raw material solution is used as the measuring object, a method to measure the water level, volume, or weight of the raw material solution 121 can be used. In this case, known sensors to detect weight or liquid level directly or indirectly can be widely applied, for example, the liquid level sensor, the load cell, or the pressure sensor installed to contact with the raw material solution 121 at the bottom of the raw material container 120, can be suitably used. In this case, the supply amount of the raw material solution to the film forming chamber 131 can be calculated as a time derivative of a measured value owing to the above sensors, etc.

An installing location and an installing method of measurement means 171 can depend on the various measuring objects or measuring methods described above and can be a form suitable for each of the objects or methods.

The measurement means 171 transmits a signal to the control means 191a and 191b according to the measured value. In this case, known methods of signal transmission methods are widely applicable, and wired or wireless communication methods using electromagnetic waves, electricity, magnetism, sound, or a combination thereof are suitably used.

In addition, the measurement means 171 may further include the calculating means 181a and 181b to compare the measured value of the measuring object with the reference value determined according to a manufacturing condition and perform an operation therebetween. In this case, the calculating means of the measurement means 171 may calculate a deviation of the measured value from the reference value to transmit the signal according to the deviation to control means 191a and 191b so as to eliminate the deviation.

### (Control Means)

Next, the control means is described. As the first form of the control means, in the present invention, it is preferable that the control means controls the atomizing means to adjust the supply amount of the raw material mist. The measurement means is not particularly limited, as long as the means directly or indirectly measures the supply amount of raw material mist and outputs a signal according to the measured value obtained from the measurement, but the control means in the following form, for example, is preferred.

Specifically, the drive circuit 123b is connected to the control means 191a by the wiring 192. The control means 191a is desirably provided with a power supply, a switch, and an output regulator for each drive circuit 123b and desirably has a configuration that allows a plurality of ultrasonic vibrators 123a to be controlled individually. This allows more precise control of the atomizing amount of the raw material solution 121. More specifically, first, the calculating means 181a compares a signal received from the measurement means 171 with the reference value to calculate the deviation; moreover, a control signal according to the deviation is sent to the control means 191a. The control means 191a is to receive the control signal to adjust the supply amount of raw material mist by individually opening and closing the drive circuit 123b or individually increasing or decreasing an applied power so as to eliminate the deviation. Note that the calculating means 181a may be integrally configured with the measurement means 171 or the control means 191a.

As the second form of the control means, in the present invention, it is preferred that the control means to control the carrier gas supply means to adjust the supply amount of raw material mist.

Specifically, the carrier gas supply means 111 is connected to the control means 191b by the wiring 193, which enables flow control of carrier gas 151. Note that the carrier gas is shown as only a single system in an example in FIG. 1; however, when the carrier gas is supplied to a plurality of systems, the control means 191b may be configured to individually adjust the supply flow rate of the carrier gas in each system.

More specifically, first, the calculating means 181b calculates the deviation by comparing the signal received from the measurement means 171 with the reference value to send the control signal according to the deviation to the control means 191b. The control means 191b receives the control signal electromagnetically or mechanically adjusts a degree of an aperture of a fluid flow regulator described above or individually opens and closes the aperture of that to adjust the supply amount of raw material mist so as to eliminate the deviation. Note that the calculating means 181b may be integrally configured with the measurement means 171 or the control means 191b.

Although FIG. 1 shows an example provided with two control means 191a and 191b; however, the inventive film forming apparatus is not limited to this but can also be the apparatus provided with only one of the control means 191a or 191b.

### (Film Forming Chamber)

The film forming chamber 131 is installed with a supply pipe 134, which is connected to the pipe 124 and supplies the gas mixture 152 into the film forming chamber 131. For example, quartz, glass, or a resin tube can be used for the supply pipe 134. In addition, the exhaust pipe 133 for exhaust gas may be installed at a location where mist supply from the supply pipe 134 is not affected. Moreover, the exhaust pipe 133 may be connected to a detoxifying means not shown in the drawing. In this case, the detoxifying means is not particularly limited as long as harmful materials contained in the exhaust gas can be removed; for example, known techniques such as a mist trap, a wet scrubber, a combustion detoxifying apparatus, and a bag filter can be widely applied.

The structure and material, etc., of the film forming chamber 131 are not particularly limited; for example, metals such as aluminum and stainless steel, soda glass, and borosilicate glass may be used, and quartz, silicon carbide, aluminum oxide, and aluminum nitride may be used for film forming at higher temperatures.

### (Stage)

A stage 132 is installed at a bottom of the film forming chamber 131, and the substrate 130 is mounted on the stage 132.

The stage 132 may be provided with means to fix and hold the substrate 130. In this case, known holding means such as a vacuum chuck, a mechanical chuck, and an electrostatic chuck can be suitably used.

Moreover, the stage 132 may be provided with means to heat the substrate 130. In this case, known heating means are applicable, and resistance heating, electromagnetic induction heating, or lamp heating are suitably used. The heating of substrate 130 is adjusted appropriately depending on the raw material mist 122 used or conditions for the film forming but can generally be in a range of 120°C to 800°C.

The material of the stage 132 may be selected appropriately according to the process conditions, such as acidity of the raw material used for film forming and a heating temperature; especially, at least part of the surface of the stage 132 is preferably made of nickel alloy, graphite, silicon carbide, aluminum oxide, aluminum nitride, or quartz, and when higher corrosion resistance is required for the raw material solution, silicon carbide, aluminum oxide, aluminum nitride, or quartz is more preferable. Note that nickel alloys refer to alloys containing nickel 50% or more.

In addition, the stage 132 may be further provided with a mechanism to transfer or rotate the substrate.

### (Mist Supply Means)

A mist supply means 160 is not particularly limited as long as the gas mixture 152 is supplied to the surface of the substrate 130. For example, the pipe 124 and the supply pipe 134 can be combined to form the mist supply means 160.

### (Pipe)

The pipes 113 and 124 are not particularly limited as long as the pipes have sufficient stability against temperatures inside and outside the raw material solution 121 and the film forming chamber 131, and especially when measuring the supply amount of mist in the pipe 124, sufficient light transmission and other properties are suitable for the aforementioned measurement; and in addition to quartz, common resin pipes such as polyethylene, polypropylene, vinyl chloride, acrylic resin, silicon resin, urethane resin, fluororesin, and the like can be widely used.

In addition, although not shown in the drawing, it is possible that a pipe is separately connected from the carrier gas supply means 111 to pipe 124, not through the raw material container 120, and then a diluent gas is added to the gas mixture 152 to adjust a ratio of the raw material mist 122 to the carrier gas 151. A flow rate of the diluent gas can be determined appropriately, e.g., 0.1 to 20 times the amount of the carrier gas. The diluent gas may be supplied to a downstream side of the raw material container 120. As the diluent gas, the same gas or a different gas from the carrier gas 151 can be used.

The inventive film forming apparatus includes a measurement means for directly or indirectly measuring a supply amount of the raw material mist to output a signal in accordance with a measured value obtained by the measurement and a control means for receiving the signal to adjust the supply amount of the raw material mist based on the signal, thereby forming a film having high uniformity in thickness, composition, and other qualities. The film forming apparatus is capable of obtaining high uniformity, not only uniformity between samples but also uniformity within films.

### [Film Forming Method]

Moreover, the present invention provides a film forming method in which a raw material mist generated by atomizing a raw material solution is supplied on a surface of a substrate to form a film on the substrate, the method including the steps of:
placing the substrate on a stage;
atomizing the raw material solution to generate the raw material mist;
mixing the raw material mist and a carrier gas to form a gas mixture and
supplying the gas mixture to the substrate to form a film on the substrate, wherein
in supplying the gas mixture to the substrate to form a film on the substrate, a supply amount of the raw material mist is measured directly or indirectly, a deviation of a measured value obtained by the measurement and the supply amount of raw material from a reference value is calculated, and one or both of an atomizing amount of the raw material solution and a supply amount of the carrier gas are adjusted so as to eliminate the deviation. That is, this is the film forming method using the inventive film forming apparatus characterized in that the raw material solution is misted, the misted raw material solution (raw material mist) is supplied to a substrate mounted on a stage of the film forming apparatus, and a film is formed on the substrate, in parallel with film forming on the substrate, an amount of the supplied raw material mist is measured (monitored), and the supply amount is controlled to maintain reference value of the supply amount.

The substrate 130 is not particularly limited as long as the film to be formed can be supported and can also be plate-shaped, such as a flat plate or a circular plate, rod-shaped, column-shaped, prism-shaped, cylinder-shaped, ring-shaped, etc. The material of the substrate 130 is also not particularly limited and can be any known material and can be an organic compound or an inorganic compound. For example, vinyl chloride, polyethylene, polyethylene terephthalate, polysulfone, polyethersulfone, polyphenylene sulfide, polyether ether ketone, polyimide, polyetherimide, fluororesin; metals such as iron and aluminum, stainless steel, and gold; quartz, glass, calcium carbonate, silicon, aluminum oxide, gallium oxide, zinc oxide, gallium nitride, silicon carbide, lithium tantalate, and lithium niobate are suitably used. When growing a crystal film, the above substrate is preferably a crystal, more preferably a single crystal.

In addition, the substrate having an area for the film forming surface area (main surface area) of preferably 15 cm² or more, more preferably 20 cm² or more, can be suitably used, and moreover, the substrate having a thickness of preferably 50 to 5000 µm, more preferably 100 to 2000 um can also be suitably used. When the thickness is 50 um or more, it is easy to support a crystal semiconductor film, and when the thickness is 5000 um or less, the temperature falls on the substrate surface due to the raw material mist is not significant, and thus, abnormal film growth can be suppressed. Moreover, when the main surface area is 15 cm² or more, the uniform film can be formed with higher productivity.

In the step of placing the substrate on the stage, a method for placing the substrate on the stage is not particularly limited, and a known method can be used.

In the step of atomizing the raw material solution to generate the raw material mist, a method for atomizing the raw material solution is not particularly limited, and a known method can be used; it is preferred to use ultrasonic waves.

In addition to the organic compound, the metal dissolved or dispersed in an organic solvent or water in a form of a complex or salt can be used as the raw material solution. In this case, acids such as hydrochloric acid, hydrobromic acid, and hydroiodic acid, and alkalis such as ammonia may be added to the solvents such as the organic solvent or water to adjust the pH of the aforementioned solvent, as necessary.

A content of solute in the raw material solution is not particularly limited and can be determined depending on purpose, and preferably 0.001 mol/L or more and 2 mol/L or less, and more preferably 0.01 mol/L or more and 0.7 mol/L or less.

In the step of mixing the raw material mist (atomized raw material solution) and the carrier gas to form the gas mixture, a method of forming the gas mixture by mixing the atomized raw material solution and the carrier gas is not particularly limited, and a known method can be used. The type of carrier gas is not particularly limited; in addition to inert gases such as nitrogen or argon, air, oxygen, ozone, or reducing gases such as hydrogen or forming gas can be used, and a mixture of a plurality of these gases can be used. The flow rate of the carrier gas may be determined appropriately according to the substrate size or the size of the film forming chamber and can be, for example, about 0.01 to 100 L/min.

In the step of supplying the gas mixture to the substrate to form the film on the substrate, a method for supplying the gas mixture to the substrate or forming the film is not particularly limited, and a known method can be used.

When the supply amount of raw material mist is measured directly or indirectly, a method of measuring the supply amount of raw material mist is not particularly limited, and all known measurement methods can be applied, including a light scattering method, a condensation nuclei counting method, an aerosol electrometer method, a piezobalance method as well as a method to weigh the mist collected by a mist trap, a filter and the like or the precipitate obtained by evaporating the liquid component of the mist, etc.

When the deviation of the measured value obtained by the above measurement from the reference value of the supply amount of raw material is calculated, a method of calculating the deviation is not particularly limited, and a known method can be used.

When adjusting either or both the atomizing amount of the raw material solution and the carrier gas supply amount to eliminate the deviation described above, a method of adjusting either or both the atomizing amount and the carrier gas supply amount is not particularly limited and known methods such as an on-off control, an PID control, and a cascade control can be used.

In addition, an object for the measurement may be any of the raw material mist, the precipitate from the raw material mist, a by-product derived from the raw material mist, or a mixture thereof.

The inventive film forming method is that in supplying the gas mixture to the substrate to form a film on the substrate, a supply amount of the raw material mist is measured directly or indirectly, a deviation of a measured value obtained by the measurement from a reference value of the supply amount of raw material is calculated, and one or both of an atomizing amount of the raw material solution and a supply amount of the carrier gas are adjusted so as to eliminate the deviation, thereby film forming with excellent uniformity of quality. The film forming method is capable of obtaining high uniformity, not only uniformity between samples but also uniformity within films.

Such a film forming method can be performed by using the inventive film forming apparatus described above.

### EXAMPLE

Hereinafter, the present invention will be specifically described with reference to Examples and Comparative Examples. However, the present invention is not limited thereto.

### (Example 1)

### [Apparatus]

In a film forming apparatus of FIG. 1, a nitrogen gas cylinder was used for a carrier gas supply portion 111, and a mass flow controller was connected to the nitrogen gas cylinder, and then the mass flow controller was connected to a raw-material container 120 made of borosilicate glass by a pipe 113 made of PFA. An ultrasonic generator, in which four ultrasonic vibrators of 2.4 MHz were arranged, was provided for an atomizing means 123. In addition, a film forming chamber 131 made of quartz was provided, and a supply pipe 134 made of quartz was connected to the raw material container 120 by a pipe 124 made of quartz. Moreover, a hot plate made of silicon carbide having a built-in resistance heating type heater was used for a stage 132.

Wide-Range Particle Spectrometer (manufactured by MSP Corporation: Model 1000XP) was used for a measurement means 171. Moreover, a control unit that also served as a power supply for driving the ultrasonic generator was used for a control means 191a, and an arithmetic circuit for controlling a mass flow controller was used for a control means 191b, which was connected to the ultrasonic generator and the mass flow controller, respectively.

### [Providing Substrate]

A c-plane sapphire substrate having a diameter of 4 inches (10 cm) and a thickness of 0.7 mm was mounted on the stage and adsorptive-immobilized by a pump, and then the temperature of the stage was maintained at 500°C by heating the stage using a heater.

### [Producing Raw Material Solution]

Gallium acetylacetonate was dissolved in an acid solution, in which hydrochloric acid and pure water were mixed, to provide a solution having a gallium concentration of 0.2 mol/L, thereby making thereof a raw material solution 121.

### [Atomizing Raw Material]

Next, the raw material solution 121 was poured into the raw material container 120, and then the raw material solution 121 was subjected to ultrasonic vibration at 2.4 MHz to atomize.

### [Film Forming]

A nitrogen gas was introduced from the nitrogen gas cylinder to the raw material container 120, and then a generated gas mixture was supplied to the film forming chamber 131 to form a film. In this case, a nitrogen flow rate was determined so as to have a flow rate of 1 g/minute of the raw material mist in the gas mixture. Note that the flow rate was a value calculated from a number of mists per unit of time measured by a measuring instrument and the density of the raw material solution measured separately.

Then, film forming was performed for 60 minutes while controlling the supply amount of the raw material by only adjusting the outputs of four ultrasonic vibrators.

The same procedures were repeated to produce a total of 20 samples.

### [Evaluation]

According to measurement by XRD (SmartLab manufactured by Rigaku Corporation), all films formed on all samples were confirmed to have α-phase Ga₂O₃.

Subsequently, film thicknesses at 24 points in planes over all samples were measured by light reflectance analysis (F50 manufactured by Filmetrics, INC) to evaluate the mean value and standard deviation among samples. The samples deviating from the mean value by 5% or more were classified as failures.

### (Example 2)

In the apparatus used in Example 1, while continuously driving four ultrasonic vibrators at a constant output, a supply amount of raw material was controlled only by adjusting the carrier gas flow rate; otherwise, film forming was performed as in Example 1.

According to measurement by XRD (SmartLab manufactured by Rigaku Corporation), all films formed on all samples were confirmed to have α-phase Ga₂O₃.

Then, an evaluation of film thickness was performed as in Example 1.

### (Comparative Example 1)

Film forming was performed in the same way as in Example 1, except that control of a supply amount of raw material was not performed.

According to measurement by XRD (SmartLab manufactured by Rigaku Corporation), films formed on all samples were confirmed to have α-phase Ga₂O₃.

Then, an evaluation of film thickness was performed as in Example 1.

Mean values and standard deviations of the film thickness, and a number of failures obtained in Examples 1, 2, and Comparative Example 1 are shown in Table 1.

**[Table 1]**

| | Mean value [um] | Standard deviation [um] | Number of failures |
|---|---|---|---|
| Example 1 | 1.66 | 0.025 | 0 |
| Example 2 | 1.65 | 0.027 | 0 |
| Comparative Example 1 | 1.77 | 0.141 | 3 |

The results described above indicated that a film-forming apparatus, according to the present invention, was capable of producing films more uniform and more stable than conventional art. In addition, according to the present invention, a reduction of the number of failures, i.e., improvement of yield, was achieved, and thus excellent productivity was indicated.

### (Example 3)

### [Apparatus]

In a film forming apparatus in FIG. 1, one set of the same raw-material container, an atomizing means, a control means, and a measurement means used in Example 1 were added in parallel, and a pipe was connected at the secondary side to two measurement means, otherwise, the same apparatus was used as in Example 1.

### [Providing Substrate]

A c-plane sapphire substrate having a diameter of 4 inches (10 cm) and a thickness of 0.7 mm was mounted on a stage and adsorptive-immobilized by a pump, and then a temperature of the stage was maintained at 500°C by heating the stage using a heater.

### [Producing Raw Material Solution]

Gallium acetylacetonate was dissolved in an acid solution, in which hydrochloric acid and pure water were mixed, to provide a gallium solution having a gallium concentration of 0.2 mol/L; and aluminum acetylacetonate was dissolved in an acid solution, in which hydrochloric acid and pure water were mixed, to provide an aluminum solution having an aluminum concentration of 0.2 mol/L; thereby making raw material solutions 121.

### [Atomizing raw material]

Next, the gallium solution and the aluminum solution were poured into two separate raw-material containers 120 and then subjected to ultrasonic vibration at 2.4 MHz to atomize.

### [Film Forming]

A nitrogen gas was introduced from a nitrogen gas cylinder to the two raw material containers 120, and then a generated gas mixture was supplied to a film forming chamber 131 to form a film. In this case, a nitrogen flow rate was determined so as to have a flow rate of 0.5 g/minute of the gallium solution mist and the aluminum solution mist in the gas mixture, respectively.

Then, film forming was performed for 60 minutes while controlling the supply amount of the raw material by only adjusting the outputs of four ultrasonic vibrators.

The same procedures were repeated to produce a total of 20 samples.

### [Evaluation]

According to XRD measurements, all films formed on all samples were confirmed to be mixed crystals of Al₂O₃ and Ga₂O₃ having α-phase. Moreover, aluminum compositions of all samples were evaluated using Vegard's rule based on XRD spectra measured at four in-plane points for each sample, and mean value and standard deviation were calculated. The samples deviating from the mean value by 5% or more were classified as failures.

### (Comparative Example 2)

Film forming was performed in the same way as in Example 3, except that control of a supply amount of raw material was not performed.

According to measurement by XRD, all films formed on all samples were confirmed as mixed crystals of Al₂O₃ and Ga₂O₃ having α-phase.

Then, an evaluation of a composition was performed as in Example 3.

Mean values, standard deviations, and a number of failures of aluminum compositions in films obtained in Example 3 and Comparative Example 2 are shown in Table 2.

**[Table 2]**

| | Mean value | Standard deviation | Number of failures |
|---|---|---|---|
| Example 3 | 0.31 | 0.007 | 0 |
| Comparative Example 2 | 0.28 | 0.018 | 4 |

It is indicated that, according to the present invention, it is possible to make the film forming apparatus capable of stably producing the film, which has smaller sample-to-sample variation in composition, and more uniformity than conventional art.

From the above results, it is indicated that the inventive film forming apparatus is the highly productive film forming apparatus that can always produce the uniform film stably. In addition, it is indicated that the inventive film forming method can produce the uniform film stably and with high productivity.

It should be noted that the present invention is not limited to the above-described embodiments. The embodiments are just examples, and any examples that have substantially the same feature and demonstrate the same functions and effects as those in the technical concept disclosed in claims of the present invention are included in the technical scope of the present invention.

## Claims

1. A film forming apparatus comprising:
an atomizing means for atomizing a raw material solution to form a raw material mist;
a carrier gas supply means to transport the raw material mist;
a mist supply means to supply a gas mixture, in which the raw material mist and the carrier gas are mixed, to a surface of a substrate;
a stage on which the substrate is placed;
a measurement means for directly or indirectly measuring a supply amount of the raw material mist to output a signal in accordance with a measured value obtained by the measurement; and
a control means for receiving the signal to adjust the supply amount of the raw material mist based on the signal.

2. The film forming apparatus, according to claim 1, wherein
the control means controls the atomizing means to adjust the supply amount of the raw material mist.

3. The film forming apparatus according to claim 1 or 2, wherein
the control means controls the carrier gas supply means to adjust the supply amount of the raw material mist.

4. A film forming method in which a raw material mist generated by atomizing a raw material solution is supplied on a surface of a substrate to form a film on the substrate, the method comprising the steps of:
placing the substrate on a stage;
atomizing the raw material solution to generate the raw material mist;
mixing the raw material mist and a carrier gas to form a gas mixture; and
supplying the gas mixture to the substrate to form a film on the substrate, wherein
in supplying the gas mixture to the substrate to form a film on the substrate, a supply amount of the raw material mist is measured directly or indirectly, a deviation of a measured value obtained by the measurement and the supply amount of raw material from a reference value is calculated, and one or both of an atomizing amount of the raw material solution and a supply amount of the carrier gas are adjusted so as to eliminate the deviation.

5. The film forming method according to claim 4, wherein
an object for the measurement is any of the raw material mist, a precipitate from the raw material mist, a by-product derived from the raw material mist, or a mixture thereof.
